# EUROPÄISCHE PATENTANMELDUNG

(11) **EP 4 280 838 A1**
(43) Veröffentlichungstag der Anmeldung: **22.11.2023**
(21) Anmeldenummer: 22174111.9
(22) Anmeldetag: 18.05.2022
(51) Int. Cl.: H05K 13/02, H05K 13/04, B65H 21/00, B65H 19/10

(54) **VORRICHTUNG UND VERFAHREN ZUM AUTOMATISCHEN VERBINDEN VON GURTEN**

(71) Anmelder: Sonplas GmbH, 94315 Straubing (DE)
(72) Erfinder: KRAML, Matthias, 94315 Straubing (DE); WILLNECKER, Manuel,, 94428 Eichendorf, (DE); BUMES Michael,, 94315 Straubing (DE); THOMA Michael,, 94362 Neukirchen, (DE); SCHWIEBACHER, Gerd,, 85419 Mauern (DE)
(74) Vertreter: Wunderlich & Heim Patentanwälte Partnerschaftsgesellschaft mbB

(57) **Zusammenfassung**

Die Erfindung betrifft eine Vorrichtung zum automatischen Verbinden von Gurten, insbesondere Bauteilgurte, wobei ein Gurtende eines ersten Gurtes mit einem Gurtanfang eines zweiten Gurtes verbunden wird und der erste Gurt und der zweite Gurt jeweils entlang ihrer Gurtlängsrichtung mit mindestens einer Lochreihe versehen sind, mit einer ersten Gurtfördereinrichtung für das Gurtende des ersten Gurtes und einer gleichgerichteten zweiten Gurtfördereinrichtung für den Gurtanfang des zweiten Gurtes, wobei zwischen den beiden Gurtfördereinrichtungen ein Verbindungsabschnitt angeordnet ist, einer Zuführeinrichtung zum Zuführen eines Verbindungselementes aus einem verformbaren Material mit einer Reihenanordnung von Verbindungsvorsprüngen, welche passend zu den Lochreihen der Gurte ausgebildet ist, in einer Querrichtung zu den Gurtlängsrichtungen und den Gurtfördereinrichtungen in den Bereich des Verbindungsabschnitts, einer Einsetzeinrichtung zum Einsetzen des Verbindungselementes in Löcher des Gurtendes des ersten Gurtes und des angrenzenden Gurtanfangs des zweiten Gurtes und einer Verformungseinrichtung zum Verformen, insbesondere Verkrimpen, der in die Löcher eingesetzten Verbindungsvorsprünge, wobei eine formschlüssige Verbindung zwischen den Gurten hergestellt wird.

## Beschreibung

Die Erfindung betrifft eine Vorrichtung zum automatischen Verbinden von Gurten, insbesondere Bauteilgurten, gemäß dem Anspruch 1.

Die Erfindung betrifft weiterhin ein Verfahren zum automatischen Verbinden von solchen Gurten gemäß dem Anspruch 11.

Bei der automatisierten oder teilautomatisierten Fertigung von Komponenten und Geräten ist es bekannt, insbesondere elektronische Bauteile, vorzugsweise sogenannte SMD-Bauelemente, auf Bauteilgurten anzuordnen, um diese einer entsprechenden Montagevorrichtung automatisch zuzufördern. Derartige Bauteilgurte weisen in ihrer Längsrichtung eine gleichbleibende Lochung oder Lochreihen für entsprechende Fördereinrichtungen zum Bewegen des Gurtes auf. Derartige Bauteilgurte sind insbesondere nach der Norm IEC 60286-3 standardisiert ausgebildet.

Solche Bauteilgurte werden zu den Montageeinrichtungen mit vorgegebenen Längen angeliefert, wobei die Montagegurte üblicherweise in einem aufgerollten Zustand angeordnet sind. Zur Sicherstellung eines ununterbrochenen Montagebetriebs ist es bei Erreichen eines Gurtendes notwendig, einen neuen Bauteilgurt am Ende des auslaufenden Bauteilgurtes rechtzeitig und positionsgenau anzubringen. Dies erfolgt in der Regel durch Personal an den Montageanlagen.

Aus der EP 0 657 092 B1 ist eine Fixierhilfe für ein manuelles Verbinden von derartigen Bauteilgurten bekannt.

Erfolgt das Anbinden eines neuen Bauteilgurtes nicht positionsgenau oder rechtzeitig, kann eine Unterbrechung oder Störung des nachfolgenden Montagevorgangs auftreten. Hierdurch kann sich insgesamt eine Störung einer gesamten Anlage ergeben, welche in vielen Fällen nur mit einem erheblichen Zeit- und Personalaufwand zu beheben ist.

Der Erfindung liegt die **Aufgabe** zugrunde, eine Vorrichtung und ein Verfahren zum Verbinden von Bauteilgurten anzugeben, mit welchen ein Verbinden positionsgenau und zuverlässig erfolgt.

Die Aufgabe wird zum einen durch eine Vorrichtung zum automatischen Verbinden von Gurten gemäß dem Anspruch 1 und zum anderen durch ein Verfahren zum automatischen Verbinden von Gurten gemäß dem Anspruch 11 gelöst. Bevorzugte Ausführungsformen der Erfindung sind in den jeweils abhängigen Ansprüchen angegeben.

Die erfindungsgemäße Vorrichtung zum automatischen Verbinden von Gurten, insbesondere Bauteilgurten, besteht darin, dass ein Gurtende eines Gurtes mit einem Gurtanfang eines zweiten Gurtes verbunden wird und der erste Gurt und der zweite Gurt jeweils entlang ihrer Gurtlängsrichtung mit mindestens einer Lochreihe versehen sind, und umfasst eine erste Gurtfördereinrichtung für das Gurtende des ersten Gurtes und eine gleichgerichtete zweite Gurtfördereinrichtung für den Gurtanfang des zweiten Gurtes, wobei zwischen den beiden Gurtfördereinrichtungen ein Verbindungsabschnitt angeordnet ist, eine Zuführeinrichtung zum Zuführen eines Verbindungselementes aus einem verformbaren Material mit einer Reihenanordnung von Verbindungsvorsprüngen, welche passend zu den Lochreihen der Gurte ausgebildet ist, in einer Querrichtung zu den Gurtlängsrichtungen und den Gurtfördereinrichtungen in den Bereich des Verbindungsabschnitts, eine Einsetzeinrichtung zum Einsetzen des Verbindungselementes in Löcher des Gurtendes des ersten Gurtes und des angrenzenden Gurtanfangs des zweiten Gurtes und eine Verformungseinrichtung, zum Verformen, insbesondere Verkrimpen, der in die Löcher eingesetzten Verbindungsvorsprünge, wobei eine Verbindung zwischen den Gurten hergestellt wird.

Eine Grundidee der Erfindung liegt darin, das Gurtende eines ersten Gurtes und den Gurtanfang eines zweiten Gurtes mittels einer Vorrichtung automatisch zu verbinden.

Hierdurch kann Bedienpersonal eingespart werden. Zudem kann das Verbinden bedarfsgerecht und zuverlässig zu jedem Zeitpunkt mit gesicherter Qualität erfolgen.

Gemäß der Erfindung ist eine erste Gurtfördereinrichtung für den ersten Gurt und eine zweite Gurtfördereinrichtung für den zweiten Gurt vorgesehen, wobei das Gurtende des ersten Gurtes und der Gurtanfang des zweiten Gurtes zumindest in einem Verbindungsabschnitt der Vorrichtung gleichgerichtet verlaufen. Die beiden Gurtfördereinrichtungen können dabei so zueinander gesteuert werden, dass das eine Gurtende und der angrenzende Gurtanfang des neuen Gurtes zum Verbinden exakt zueinander positioniert werden. Die Fördereinrichtungen für den Gurt können ein oder mehrere Förderräder mit radial vorstehenden Fördernocken aufweisen, welche in die Löcher der Lochreihe des Gurtes eingreifen und so durch Drehung den Gurt linear in der Förderrichtung bewegen und verschieben. Der Gurt kann angehoben werden, um dem folgenden Bestückungsautomaten ein Weiterarbeiten während dem Verbinden oder Splicen zu ermöglichen.

Über eine Zuführeinrichtung kann bei einer entsprechenden Ausrichtung von Gurtende und Gurtanfang ein Verbindungselement positionsgenau so zugefördert werden, dass Verbindungsvorsprünge des Verbindungselementes passend in die Lochreihen mittels einer Einsetzeinrichtung eingesetzt werden können. Nach diesem Einsetzen des verformbaren Verbindungselementes werden die eingesetzten Verbindungsvorsprünge derart verformt, dass eine vorzugsweise formschlüssige Verbindung zwischen den zwei angrenzenden Gurten hergestellt ist.

Das Verbindungselement kann dabei aus jedem geeigneten verformbaren Material hergestellt sein, insbesondere einem plastisch verformbaren Metall, etwa aus Kupfer oder einer Kupferlegierung, oder auch aus einem plastisch verformbaren Kunststoff. Insbesondere ist ein Einsatz von branchenüblichen Spliceclips möglich.

Eine vorteilhafte Weiterbildung der erfindungsgemäßen Vorrichtung besteht darin, dass im Bereich des Verbindungsabschnitts mindestens eine Trenneinrichtung angeordnet ist, welche zum Abtrennen eines Gurtabschnittes des ersten Gurtes und/oder des zweiten Gurtes ausgebildet ist. Durch die Trenneinrichtung kann unabhängig vom Zulieferzustand des jeweiligen Gurtes ein sauberes oder exaktes Gurtende beziehungsweise ein sauberer oder exakter Gurtanfang durch Abtrennen des jeweiligen End- oder Randstücks bewirkt werden. Es können so saubere Stoßkanten hergestellt werden, die eine exakte Positionierung des Gurtendes und des Gurtanfangs zueinander erlauben. Zudem kann die mindestens eine Trenneinrichtung so ausgebildet und angeordnet sein, dass das Abtrennen der Randstücke so erfolgt, dass bei den auf Stoß angrenzenden Gurten eine Reihenfolge der Lochung mit einem gleichbleibenden Lochabstand gegeben ist.

Der Trennvorgang kann dabei über eine einzige Trennvorrichtung für nur einen Gurt oder beide Gurte oder über zwei Trennvorrichtungen vorgesehen werden, wobei eine Trennvorrichtung jeweils nur einem Gurt zugeordnet ist.

Grundsätzlich kann die Trenneinrichtung in jeder geeigneten Weise ausgebildet sein. Besonders vorteilhaft ist es nach einer Ausführungsform der Erfindung, dass die Trenneinrichtung mindestens eine Schneide oder eine Einheit zum Erzeugen eines Trennstrahls, insbesondere eines Laserstrahls, aufweist. Die Trenneinrichtung kann stationär oder auch als eine mitlaufende Trenneinrichtung zum Beschneiden eines sich bewegenden Gurtes ausgebildet sein. Insgesamt kann ein sauberer Randabschnitt hergestellt und so eine gute Verbindung vorbereitet werden.

Besonders bevorzugt ist es nach einer Ausführung der Erfindung, dass die Zuführeinrichtung ein Magazin zum Bevorraten einer Vielzahl von Verbindungselementen aufweist. Das Magazin kann im Bereich der Verbindungsstelle sein und zum bedarfsgerechten Bereitstellen und Zuführen eines Verbindungselementes ausgebildet sein.

Besonders vorteilhaft ist es dabei, dass eine Vielzahl von Verbindungselementen als ein zusammenhängendes Band ausgebildet ist, wobei die Zuführeinrichtung eine Fördereinrichtung zum Fördern des Bandes zum Verbindungsabschnitt aufweist, und dass eine Abtrenneinheit vorgesehen ist, mit welcher ein einzelnes Verbindungselement vor oder beim Verformen von dem Band abtrennbar ist. Es können so auch sehr kleine und feine Verbindungselemente durch eine zusammenhängende Ausbildung gelagert und zugeführt werden. Die Verbindungselemente können dabei eine Breite von einem oder nur wenigen Millimetern aufweisen und eine Länge von wenigen Millimetern bis zu einigen Zentimetern.

Das Verbindungselement ist dabei vorzugsweise aus einem dünnen Blech gebildet, welches eine Materialstärke von vorzugsweise unter 1 Millimeter, insbesondere von wenigen Zehntelmillimetern aufweist.

Insbesondere kann eine Vielzahl von Verbindungselementen aus einem Blechband zusammenhängend in effizienter Weise hergestellt und bereitgestellt werden. Durch ein Abtrennen des jeweils benötigten Verbindungselementes erst unmittelbar vor dem Einsetzen in die Lochreihen wird ein positionsgenaues Lagern und Zuführen ermöglicht. Die Abtrenneinrichtung kann mit einer Schneide, insbesondere einem Stanzmesser oder über einen Trennstrahl, insbesondere einem Laserstrahl, erfolgen.

Besonders zweckmäßig ist es nach einer Weiterbildung der Erfindung, dass die Abtrenneinheit zusammen mit der Verformungseinrichtung ausgebildet ist. Die Verformungseinrichtung weist insbesondere einen in einer Hubrichtung verfahrbaren Stempel mit Umformwerkzeugen auf, durch welche die Umformvorsprünge an den Verbindungselementen ähnlich einer Vernietung umgeformt und verbreitert werden können, so dass sich eine formschlüssige Verbindung ergibt. Aufgrund der Hubbewegung der Verformungseinrichtung kann die Abtrenneinheit mit einem Schneid- oder Stanzwerkzeug unmittelbar mit der Verformungseinrichtung kombiniert werden.

Eine weitere Verbesserung im Betriebsablauf wird nach einer Weiterentwicklung der Erfindung dadurch erzielt, dass in Förderrichtung nach der Verbindungseinrichtung eine Abdeckeinrichtung angeordnet ist, mit welcher ein Abdeckelement auf die Verbindungsstelle der zwei verbundenen Gurte aufbringbar, insbesondere aufklebbar ist.

Das Abdeckelement kann eine Folie oder dünne Platte sein, die vorzugsweise auf einer Seite mit einer Klebeschicht versehen ist. Durch die Abdeckung der Verbindungsstelle werden Störungen beim weiteren Montageablauf mit hoher Sicherheit vermieden.

Für einen guten Betriebsablauf ist es nach einer Weiterbildung der Erfindung bevorzugt, dass mindestens ein Sensorelement vorgesehen ist, durch welches ein Gurtende des ersten Gurtes und/oder ein Gurtanfang des zweiten Gurtes erfassbar ist. Die Sensoreinrichtung kann dabei mit einer Steuereinrichtung verbunden sein, durch welche auch die Trennvorrichtung, die Zuführeinrichtung, die Einsetzvorrichtung und/oder die Abdeckeinrichtung gesteuert werden.

Eine weitere bevorzugte Ausführungsvariante der Erfindung besteht darin, dass eine Steuereinrichtung vorgesehen ist, welche ausgebildet ist, bei Auftreten eines Gurtendes im Bereich des Verbindungsabschnitts die Vorrichtung zum Durchführen eines automatischen Verbindungsverfahrens zu veranlassen, wobei ein Gurtanfang des zweiten Gurtes in den Verbindungsabschnitt an das Gurtende des ersten Gurtes zugeführt wird. Dabei können dann auch ein oder zwei Beschneidungsvorgänge durchgeführt werden. Durch die Steuereinrichtung kann insbesondere die Zuförderung des neuen zweiten Gurtes veranlasst werden, so dass das Gurtende einerseits und der Gurtanfang andererseits sich in einer Verbindungsposition gegenüberliegen oder auf Stoß aneinander angrenzen. In dieser Position kann dann das Verbinden mit dem mindestens einen Verbindungselement erfolgen.

Die Erfindung umfasst weiterhin eine Anlage zum automatischen Bestücken von Bauteilen, insbesondere elektronischen Bauelementen, welche mittels eines Gurtes und mindestens einer Zufördereinrichtung automatisch zu einer Bestückungsstation gefördert werden, wobei nach der Erfindung an der mindestens einen Zufördereinrichtung eine Vorrichtung zum automatischen Verbinden von Gurten gemäß der Erfindung vorgesehen ist. Die Anlage kann somit vollständig oder weitgehend automatisiert sein, wobei durch das automatische Verbinden der Gurte eine Reduzierung von Bedienpersonal oder sogar ein Wegfall von Bedienpersonal erfolgen kann. In vorteilhafter Weise kann eine derartige Anlage, welche auch als Bestückungsautomat bezeichnet werden kann, in einem Mehrschichtbetrieb, insbesondere in einem 24-Stunden-Betrieb eingesetzt werden.

Auf den Gurten können verschiedenste Bauteile, insbesondere elektronische Bauelemente angeordnet sein, wie sie insbesondere für die Herstellung von elektronischen und/oder elektrischen Geräten benötigt werden. Grundsätzlich können an den Gurten auch andere Bauelemente oder Bauteile vorgesehen sein.

Das erfindungsgemäße Verfahren zum automatischen Verbinden von Gurten ist insbesondere durch den Einsatz der erfindungsgemäßen Vorrichtung gekennzeichnet. Dabei können die zuvor beschriebenen Vorteile erzielt werden.

Insbesondere ist es erfindungsgemäß, dass der erste Gurt mit einem Gurtende mittels einer ersten Gurtfördereinrichtung gefördert wird und der zweite Gurt mit einem Gurtanfang mit einer gleichgerichteten zweiten Gurtfördereinrichtung gefördert wird, wobei zwischen den beiden Gurtfördereinrichtungen ein Verbindungsabschnitt angeordnet ist, dass mittels einer Zuführeinrichtung ein Verbindungselement aus einem verformbaren Material mit einer Reihenanordnung von Verbindungsvorsprüngen, welche passend zu den Lochreihen der Gurte ausgebildet sind, in einer Querrichtung zu den Gurtlängsrichtungen und den Gurtfördereinrichtungen in dem Bereich des Verbindungsabschnitts zugeführt wird, dass mittels einer Einsetzeinrichtung das Verbindungselement in die Löcher des Gurtendes des ersten Gurtes und das angrenzenden Gurtanfangs des zweiten Gurtes eingesetzt wird und dass mittels einer Verformungseinrichtung die in die Löcher eingesetzten Verbindungsvorsprünge verformt, insbesondere verkrimpt werden, wobei eine formschlüssige Verbindung zwischen den Gurten hergestellt wird. Insgesamt kann so eine effiziente und zuverlässige Verbindung zwischen zwei Bauteilgurten erreicht werden.

Die Erfindung wird nachfolgend anhand von bevorzugten Ausführungsbeispielen weiter beschrieben, welche schematisch in den beigefügten Zeichnungen dargestellt sind. In den Zeichnungen zeigen:
- Fig. 1: eine perspektivische Ansicht einer erfindungsgemäßen Vorrichtung zum automatischen Verbinden von Gurten;
- Fig. 2: eine Draufsicht auf die Vorrichtung von Figur 1 von oben;
- Fig. 3: eine perspektivische Ansicht zu einer Gurtfördereinrichtung;
- Fig. 4: eine perspektivische Ansicht zu einer Trenneinrichtung;
- Fig. 5: eine perspektivische Ansicht zu einer Einsetzeinrichtung und einer Verformungseinrichtung; und

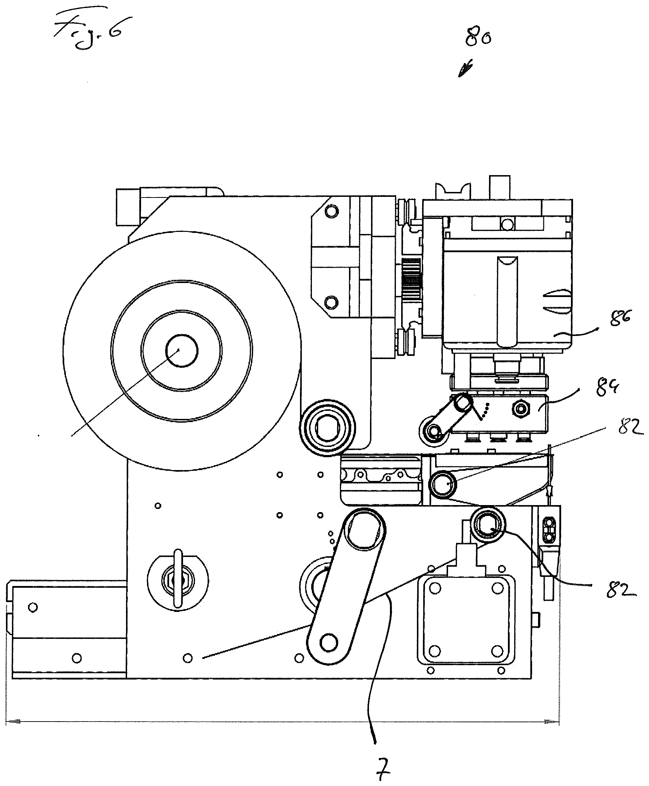

- Fig. 6: eine Seitenansicht zu einer Abdeckeinrichtung.

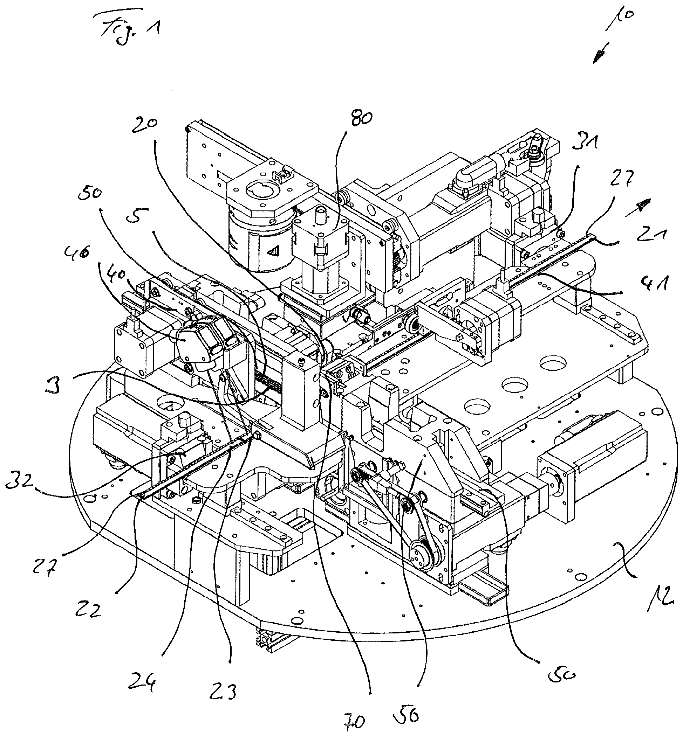

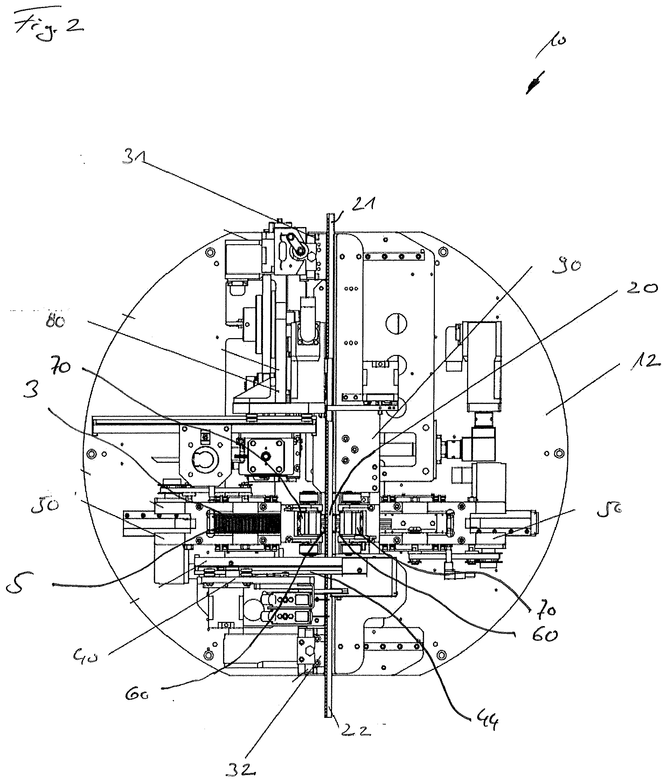

In den Figuren 1 und 2 ist der grundsätzliche Aufbau einer möglichen Ausführungsform einer erfindungsgemäßen Vorrichtung 10 zum automatischen Verbinden eines ersten Gurtes 21 und eines zweiten Gurtes 22 dargestellt, welche jeweils mit in Reihe angeordneten Löchern 27 versehen sind. Auf den Gurten 21, 22 können Bauteile, insbesondere elektronische Bauelemente, angeordnet sein. Aus Gründen der Übersichtlichkeit sind die Bauelemente nicht dargestellt. Eine Förderrichtung der Gurte 21, 22 ist Figur 1 mit einem Pfeil dargestellt. Die Vorrichtung 10 ist konkret zum automatischen Verbinden eines Gurtendes 23 des in Förderrichtung des ersten Gurtes 21 mit einem Gurtanfang 24 eines in Förderrichtung nachfolgenden zweiten Gurtes 22 ausgebildet. Zum Bilden der Vorrichtung 10 sind auf einer Grundplatte 12 verschiedene Komponenten und Einrichtungen angeordnet, welche im Weiteren näher erläutert werden.

Zum Fördern des vorausgehenden ersten Gurtes 21 sind eine erste Gurtfördereinrichtung 31 und zum Fördern des zweiten Gurtes 22 eine zweite Gurtfördereinrichtung 32 entlang einer gemeinsamen Linearführung oder Führungsbahn 41 für die beiden Gurte 21, 22 vorgesehen. Das Gurtende 23 und der Gurtanfang 24 können eingangs der Vorrichtung 10 mittels einer Sensoreinrichtung 46 erkannt werden.

Die Vorrichtung 10 ist mit einer Trenneinrichtung 40 versehen, mit welchen das Gurtende 23 und/oder der Gurtanfang 24 gezielt beschnitten werden können, um beide Teile exakt auf Stoß aneinander fügen zu können.

In einem Verbindungsabschnitt 20 etwa in der Mitte der Vorrichtung 10 kann ein Verbinden des ersten Gurtes 21 mit dem zweiten Gurt 22 mittels Verbindungselementen 5 erfolgen, welche als ein zusammenhängendes Band 3 quer zur Längsrichtung der Gurte 21, 22 mittels einer Zuführeinrichtung 50 zugeführt werden. Bei der dargestellten Vorrichtung 10 sind zu beiden Längsseiten der Gurte 21, 22 je eine Zuführvorrichtung 50 mit einer jeweiligen Einsetzvorrichtung 60 zum Einsetzen der Verbindungselemente 5 in Löcher 27 der aneinander angrenzenden Gurte 21, 22 sowie jeweils eine Verformungseinrichtung 70 angeordnet. Die Verformungseinrichtung 70 dient dazu, die in die Löcher 27 der Gurte 21, 22 eingesetzten Verbindungselemente 5 zu verformen, insbesondere zu verkrimpen, um so eine formschlüssige und optional auch eine kraftschlüssige Verbindung zwischen dem Gurtende 23 und dem Gurtanfang 24 zur erreichen.

In Förderrichtung der Gurte 21, 22 nachfolgend ist eine Abdeckeinrichtung 80 angeordnet, mit welcher ein Abdeckelement auf die Verbindungsstelle zwischen den Gurten 21, 22 aufgebracht werden kann.

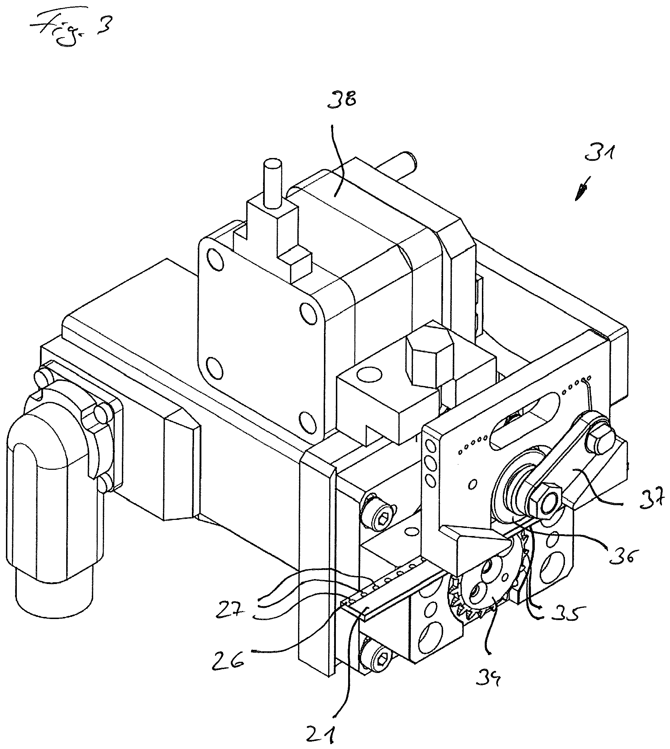

Die erste Gurtfördereinrichtung 31 kann im Wesentlichen gleich zu der zweiten Gurtfördereinrichtung 32 ausgebildet sein, wobei die erste Gurtfördereinrichtung 31 vergrößert in Figur 3 dargestellt ist. Über einen Förderantrieb 38 wird ein Förderrad 34 mit außenliegenden zahnartigen Nocken 35 drehend angetrieben. Die Nocken 35 können dabei in die Löcher 27 des Gurtes 21 eingreifen und so eine Vorschubbewegung des Gurtes 21 bewirken. Die Löcher 27 sind zum Bilden einer standardisierten Lochung 26 in einer Linie oder Reihe mit einem gleichmäßigen Lochabstand zueinander ausgebildet.

Gegenüber liegend zu dem Förderrad 34 kann ein Andruckrad 36 vorgesehen sein, welches drehbar an einem Schwenkhebel 37 gelagert ist. Aufgrund der angelenkten Lagerung der Andruckrades 36 kann dieses von oben auf den Gurt 21 drücken und so eine hinreichende Andruckkraft gegenüberliegend zu dem Förderrad 34 bewirken.

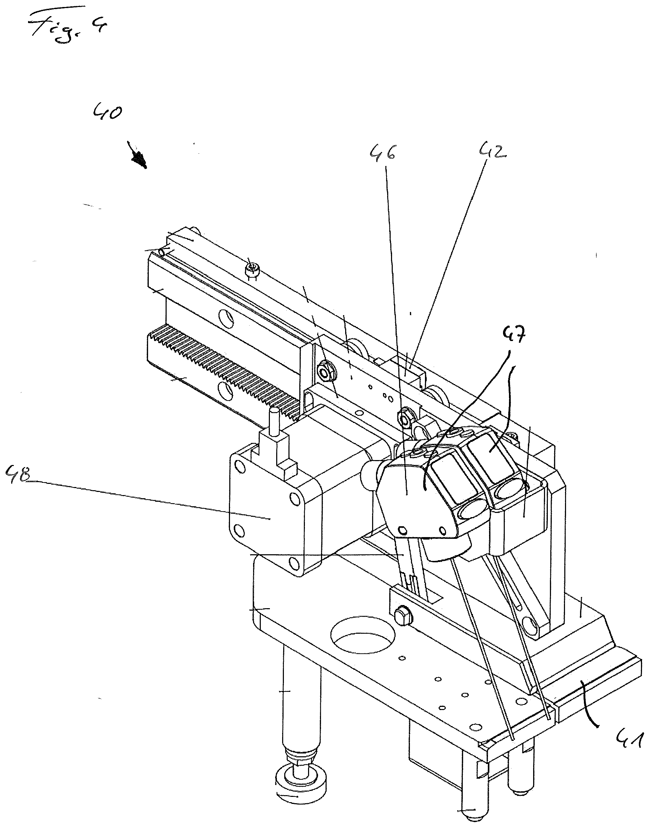

Entlang einer Führungsbahn 41 für die Gurte 21, 22 ist in einem Eingangsbereich der Vorrichtung 10 eine Trennvorrichtung 40 angeordnet, welche näher in Figur 4 dargestellt ist. Die Trennvorrichtung 40 weist dabei eine Sensoreinrichtung 46 vorzugsweise mit zwei optischen Sensoreinheiten 47 auf, mit welchen das Vorliegen eines Gurtendes 23 eines vorausgehenden ersten Gurtes 21 festgestellt werden kann. Typischerweise können an den Gurten 21, 22 am Anfang und am Ende Leerstellen ohne Bauelemente vorgesehen sein, welche von der Sensoreinrichtung 46 erfasst werden können. In einem solchen Fall kann über die zweite Gurtfördereinrichtung 32 ein zweiter Gurt 22 bis an den ersten Gurt 21 herangefördert werden. Der Gurtanfang 24 des zweiten Gurtes 22 kann ebenfalls durch die Sensoreinrichtung 46 festgestellt werden. Zum Entfernen eines unsauberen Gurtabschlusses kann durch die Trenneinrichtung 40 ein Schneidmechanismus 42 mittels eines Schneidantriebs 48 betätigt werden, wobei eine in Figur 4 verdeckte Schneide aus einer Rückzugsposition in eine Schneidposition verfahren wird, wobei ein Beschneiden des ersten Gurtes 21 oder des zweiten Gurtes 22 erfolgt. Nach dem Beschneiden oder Abtrennen wird die Schneide über den Schneidmechanismus 42 wieder in die Rückzugsposition gemäß Figur 4 rückgestellt.

Nach dem Beschneidvorgang durch die Trenneinrichtung 40 kann über die zweite Gurtfördereinrichtung 32 der nachfolgende zweite Gurt 22 auf Stoß an den vorausgehenden ersten Gurt 21 zugestellt werden, wobei die beiden Gurte 21, 22 mit ihren aneinander anliegenden Gurtende 23 und Gurtanfang 24 in den Verbindungsabschnitt 20 der Vorrichtung 10 gemeinsam gefördert werden.

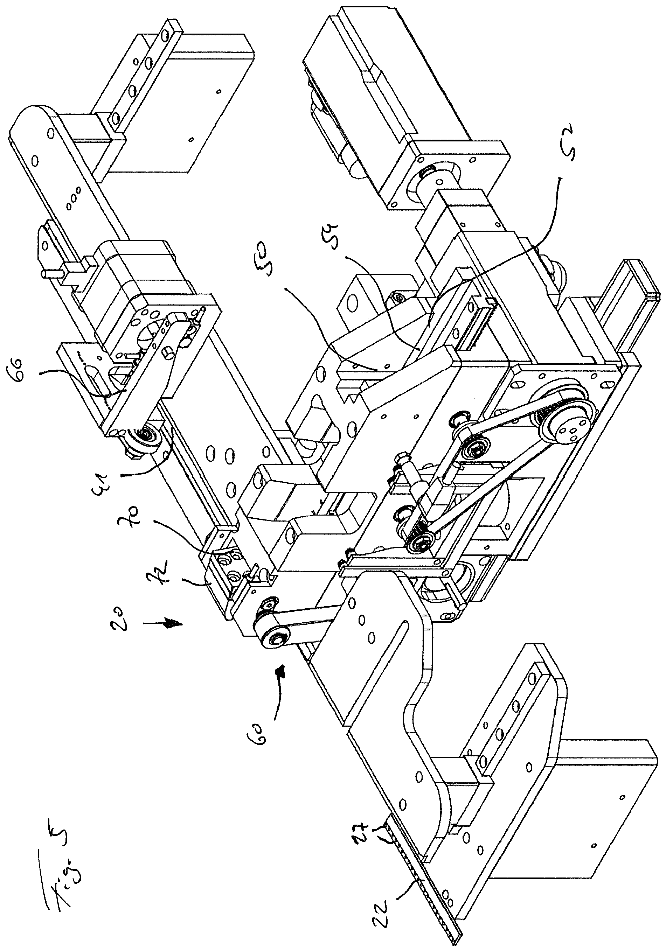

Im Bereich des Verbindungsabschnitts 20 sind zu beiden Längsseiten der Gurte 21, 22 je eine Zuführeinrichtung 50, eine Einsetzeinrichtung 60 und eine Verformungseinrichtung 70 zum Verbinden, insbesondere zum sogenannten Splicen, der beide Gurte 21, 22 vorgesehen. In Figur 5 ist eine Verbindungsanordnung mit einer Zuführeinrichtung 50, einer Einsetzeinrichtung 60 und einer Verformungseinrichtung 70 auf einer Längsseite der Gurte 21, 22 dargestellt, wobei auf der gegenüberliegenden Längsseite eine entsprechende Anordnung vorgesehen ist, wie auch in den Figuren 1 und 2 dargestellt.

Quer zur Längsrichtung des in Figur 5 allein und nur teilweise dargestellten zweiten Gurtes 22 wird ein nicht dargestelltes Band mit Verbindungselementen entlang einer Führung 52 einer Zuführeinrichtung 50 über einen Zuführantrieb schrittweise zugeführt. Die längliche Führung 52 dient dabei gleichzeitig als ein Magazin 54 zum Lagern einer Vielzahl von Verbindungselementen.

Bei Vorliegen einer Stoß- oder Verbindungsstelle zwischen zwei aneinandergrenzenden Gurten 21, 22 dient die Zuführeinrichtung 50 gleichzeitig als eine Einsetzeinrichtung 60, um insbesondere Verbindungselemente 5 aus einem Blech mit vorstehenden Verbindungsnoppen in die an die Verbindungsstelle angrenzenden Löcher 27 der Gurte 21, 22 einzusetzen.

Anschließend wird über eine Verformungseinrichtung 70 mit einem schwenkbar gelagerten Stempel 72 ein Einformen der streifenförmigen Verbindungselemente in die Löcher 27 der Gurte 21, 22 und ein Verformen der Verbindungsvorsprünge oder Noppen bewirkt, um so eine zumindest formschlüssige Verbindung zwischen den zwei aneinandergrenzenden Gurten 21, 22 zu bewirken. Zum Verformen wird der Stempel 72, welcher in Figur 5 in seiner nach oben geschwenkten Ruheposition gezeigt ist, in eine Verformungsposition nach unten verschwenkt. Hierdurch wird eine plastische Verformung am Verbindungselement bewirkt. Gleichzeitig kann mittels einer nicht dargestellten Schneidkante als Abtrenneinheit an dem Stempel 27 ein Abtrennen des Verbindungselementes von dem Band bewirkt werden.

Weiter kann eine Einstelleinrichtung 66 vorgesehen sein, mit welcher eine Breite der Führungsbahn 41 an eine geänderte Breite eines Gurtes 21, 22 eingestellt werden kann, wie schematisch in Figur 5 dargestellt ist.

Als eine weitere Option kann in Förderrichtung anschließend an die Verformungseinrichtung 70 eine Abdeckeinrichtung 80 angeordnet sein, mit welcher ein Abdeckelement 7, insbesondere ein Klebestreifen, auf die Verbindungsstelle zwischen den zwei Gurten 21, 22 aufgebracht werden kann. Das Verbindungselement 7 kann dabei über eine Zuführung mit Rollen 82 in den Bereich der Gurte 21, 22 gefördert werden. Mittels eines oberhalb der Verbindungsstelle angeordneten Hubzylinders 86 mit einem Andruckstempel 84 kann das Abdeckelement 7 auf die Verbindungsstelle an den Gurten 21, 22 aufgebracht und insbesondere aufgeklebt werden. An dem Andruckstempel 84 kann ebenfalls eine Schneide angebracht sein, mit welcher ein Ablängen eines bandförmigen zugeführten Abdeckelementes 7 bewirkt wird.

## Patentansprüche

1. Vorrichtung (10) zum automatischen Verbinden von Gurten (21, 22), insbesondere Bauteilgurten, wobei ein Gurtende (23) eines ersten Gurtes (21) mit einem Gurtanfang (24) eines zweiten Gurtes (22) verbunden wird und der erste Gurt (21) und der zweite Gurt (22) jeweils entlang ihrer Gurtlängsrichtung mit mindestens einer Lochreihe versehen sind, mit
- einer ersten Gurtfördereinrichtung (31) für das Gurtende (23) des ersten Gurtes (21) und einer gleichgerichteten zweiten Gurtfördereinrichtung (32) für den Gurtanfang (24) des zweiten Gurtes (22), wobei zwischen den beiden Gurtfördereinrichtungen (31, 32) ein Verbindungsabschnitt (20) angeordnet ist,
- einer Zuführeinrichtung (50) zum Zuführen eines Verbindungselementes (5) aus einem verformbaren Material mit einer Reihenanordnung von Verbindungsvorsprüngen, welche passend zu den Lochreihen der Gurte (21, 22) ausgebildet ist, in einer Querrichtung zu den Gurtlängsrichtungen und den Gurtfördereinrichtungen (31,32) in den Bereich des Verbindungsabschnitts (20),
- einer Einsetzeinrichtung (60) zum Einsetzen des Verbindungselementes (5) in Löcher (27) des Gurtendes (23) des ersten Gurtes (21) und des angrenzenden Gurtanfangs (24) des zweiten Gurtes (22) und
- einer Verformungseinrichtung (70) zum Verformen, insbesondere Verkrimpen, der in die Löcher (27) eingesetzten Verbindungsvorsprünge, wobei eine Verbindung zwischen den Gurten (21, 22) hergestellt wird.

2. Vorrichtung nach Anspruch 1,
**dadurch gekennzeichnet,**
**dass** im Bereich des Verbindungsabschnitts (20) mindestens eine Trenneinrichtung (40) angeordnet ist, welche zum Abtrennen eines Gurtabschnittes des ersten Gurtes (21) und/oder des zweiten Gurtes (22) ausgebildet ist.

3. Vorrichtung nach Anspruch 2,
**dadurch gekennzeichnet,**
**dass** die Trenneinrichtung (40) mindestens eine Schneide oder eine Einheit zum Erzeugen eines Trennstrahls, insbesondere eine Laserstrahls, aufweist.

4. Vorrichtung nach einem der Ansprüche 1 bis 3,
**dadurch gekennzeichnet,**
**dass** die Zuführeinrichtung (50) ein Magazin (54) zum Bevorraten einer Vielzahl von Verbindungselementen (5) aufweist.

5. Vorrichtung nach Anspruch 4,
**dadurch gekennzeichnet,**
**dass** eine Vielzahl von Verbindungselementen (5) als ein zusammenhängendes Band (3) ausgebildet ist, wobei die Zuführeinrichtung (50) eine Fördereinrichtung zum Fördern des Bandes (3) zum Verbindungsabschnitt (20) aufweist, und dass eine Abtrenneinheit vorgesehen ist, mit welcher ein einzelnes Verbindungselement (5) vor oder beim Verformen von dem Band (3) abtrennbar ist.

6. Vorrichtung nach Anspruch 5,
**dadurch gekennzeichnet,**
**dass** die Abtrenneinheit zusammen mit der Verformungseinrichtung (70) ausgebildet ist.

7. Vorrichtung nach einem der Ansprüche 1 bis 6,
**dadurch gekennzeichnet,**
**dass** in Förderrichtung nach der Verbindungseinrichtung eine Abdeckeinrichtung (80) angeordnet ist, mit welcher ein Abdeckelement (7) auf die Verbindungsstelle der zwei verbundenen Gurte (21, 22) aufbringbar, insbesondere aufklebbar, ist.

8. Vorrichtung nach einem der Ansprüche 1 bis 7,
**dadurch gekennzeichnet,**
**dass** mindestens ein Sensorelement (47) vorgesehen ist, durch welches ein Gurtende (23) des ersten Gurtes (21) und/oder ein Gurtanfang (24) des zweiten Gurtes (22) erfassbar ist.

9. Vorrichtung nach einem der Ansprüche 1 bis 8,
**dadurch gekennzeichnet,**
**dass** eine Steuereinrichtung vorgesehen ist, welche ausgebildet ist, bei Auftreten eines Gurtendes (23) im Bereich des Verbindungsabschnitts (20) die Vorrichtung (10) zum Durchführen eines automatischen Verbindungsverfahrens zu veranlassen, wobei ein Gurtanfang (24) des zweiten Gurtes (22) in den Verbindungsabschnitt (20) an das Gurtende (23) des ersten Gurtes (21) zugeführt wird.

10. Anlage zum automatischen Bestücken von Bauteilen, insbesondere elektronischen Bauelementen, welche mittels eines Gurtes (21, 22) und mindestens einer Zufördereinrichtung automatisch zu einer Bestückungsstation gefördert werden,
**dadurch gekennzeichnet,**
**dass** an der mindestens einen Zufördereinrichtung eine Vorrichtung (10) zum automatischen Verbinden von Gurten (21, 22) nach einem der Ansprüche 1 bis 9 vorgesehen ist.

11. Verfahren zum automatischen Verbinden von Gurten (21, 22), insbesondere Bauteilgurten, wobei ein Gurtende (23) eines ersten Gurtes (21) mit einem Gurtanfang (24) eines zweiten Gurtes (22) verbunden wird und der erste Gurt (21) und der zweite Gurt (22) jeweils entlang ihrer Gurtlängsrichtung mit mindestens einer Lochreihe versehen sind,
wobei das Verfahren mit einer Vorrichtung (10) nach einem der Ansprüche 1 bis 10 ausgeführt wird.

12. Verfahren nach Anspruch 11,
**dadurch gekennzeichnet,**
**dass** der erste Gurt (21) mit einem Gurtende (23) mittels einer ersten Gurtfördereinrichtung (31) gefördert wird und der zweite Gurt (22) mit einem Gurtanfang (24) mit einer gleichgerichteten zweiten Gurtfördereinrichtung (32) gefördert wird, wobei zwischen den beiden Gurtfördereinrichtungen (31, 32) ein Verbindungsabschnitt (20) angeordnet ist,
**dass** mittels einer Zuführeinrichtung (50) ein Verbindungselement (5) aus einem verformbaren Material mit einer Reihenanordnung von Verbindungsvorsprüngen, welche passend zu den Lochreihen der Gurte (21, 22) ausgebildet sind, in einer Querrichtung zu den Gurtlängsrichtungen und den Gurtfördereinrichtungen (31, 32) in den Bereich des Verbindungsabschnitts (10) zugeführt wird,
**dass** mittels einer Einsetzeinrichtung (60) das Verbindungselement (5) in die Löcher (27) des Gurtendes (23) des ersten Gurtes (21) und des angrenzenden Gurtanfangs (24) des zweiten Gurtes (22) eingesetzt wird und
**dass** mittels einer Verformungseinrichtung (70) die in die Löcher (27) eingesetzten Verbindungsvorsprünge verformt, insbesondere verkrimpt, werden, wobei eine formschlüssige Verbindung zwischen den Gurten (21, 22) hergestellt wird.
